# EUROPEAN PATENT APPLICATION

(11) **EP 4 322 235 A1**
(43) Date of publication of application: **14.02.2024**
(21) Application number: 22784899.1
(22) Date of filing: 05.04.2022
(51) Int. Cl.: H01L 51/42, H01L 51/44, H01L 27/30

(54) **PEROVSKITE SOLAR CELL AND TANDEM SOLAR CELL COMPRISING SAME**

(30) Priority: 07.04.2021 KR 20210045300
(71) Applicant: Hanwha Solutions Corporation, Jung-gu Seoul 04541 (KR)
(72) Inventor: JUNG, Jin Young, Seoul 05275 (KR); YANG, Woon Seok, Yongin-si Gyeonggi-do 16941 (KR); YI, Min Ji, Seoul 07691 (KR); CHOI, In Taek, Bucheon-si Gyeonggi-do 14787 (KR)
(74) Representative: Mooser, Sebastian Thomas
(86) International application number: PCT/KR2022/004831
(87) International publication number: WO 2022/215990

(57) **Abstract**

The present invention relates to a perovskite solar cell and a tandem solar cell comprising the same, characterized in that the perovskite solar cell comprises: a substrate; a transparent electrode; a hole transport layer; a perovskite light absorption layer; an electron transport layer; and a metal electrode, wherein the electron transport layer is a graded thin film in which a chemical binding state of elements constituting the electron transport layer gradually changes from the lower portion thereof toward the upper portion thereof.

## Description

### [Technical Field]

The present invention relates to a perovskite solar cell and a tandem solar cell including the same, and more particularly to a perovskite solar cell including an improved electrode transport layer formed by atomic layer deposition and a tandem solar cell including the same.

### [Background Art]

A solar cell refers to an assembly configured to convert solar energy into electricity and has been studied as a next-generation energy source for a long period of time. Various reports say that high photoelectric efficiencies can be achieved using solar cells based on a variety of materials, including silicon, CIGS, perovskite, and the like. Currently, most commercially available solar cells are silicon solar cells, which occupy 90% or more of the solar cell market.

Silicon solar cells include crystalline silicon solar cells and non-crystalline silicon solar cells. Despite a disadvantage of high manufacturing costs, crystalline silicon solar cells are widely commercialized due to high energy efficiency thereof. On the contrary, the non-crystalline silicon solar cells are currently underdeveloped due to their difficult processing technology, high equipment dependency, and, most importantly, low efficiency. If silicon solar cells are classified as first generation solar cells, perovskite solar cells are representative third generation solar cells, which are actively researched worldwide as a promising eco-friendly future.

The perovskite solar cells are manufactured using a material having a perovskite crystal structure formed through combination of an organic material and an inorganic material. Perovskite has a very special structure that exhibits superconductivity along with nonconductor-semiconductor-conductor properties.

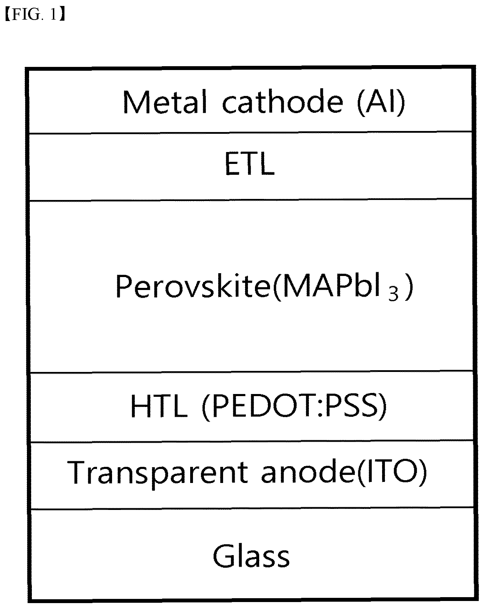

Since such an organic-inorganic hybrid perovskite solar cell can be manufactured at low cost and is formed as a thin film through a solution process, organic-inorganic hybrid perovskite solar cells are attracting attention as next generation thin-film solar cells. Referring to FIG. 1, a typical perovskite solar cell has a structure in which a glass substrate, a transparent electrode (anode), a hole transport layer (HTL), a light absorption layer (perovskite), an electron transport layer (ETL), and a metal electrode (cathode) are sequentially stacked. Here, the transparent electrode includes an indium tin oxide (ITO) or a fluorine-doped tin oxide (FTO), which has low work function, and the metal electrode includes Au or Ag, which has high work function.

In the decade since research on perovskite solar cells began, efficiency of perovskite solar cells is rapidly increased together with reports of high photoelectric efficiency thereof. However, such single-junction solar cells can only absorb solar energy in a limited wavelength region and suffer from degradation loss for solar energy below the bandgap, thereby making it difficult to achieve high efficiency above the S-Q limit.

To compensate for such shortcomings of the single-junction perovskite solar cells, research continues on multi-junction tandem solar cells. In a multi-junction tandem solar cell, an upper cell having a wide bandgap absorbs solar energy in a low wavelength band and a lower cell having a narrow bandgap absorbs solar energy in a high wavelength band, thereby suppressing energy loss while harvesting solar energy in a wide range of wavelengths at a high efficiency of 30% or more, which cannot be achieved by a single junction.

In particular, various studied have been made to develop a perovskite silicon tandem solar cell that has a narrow bandgap and a wide bandgap to be advantageous in harvesting solar energy.

One problem of the perovskite solar cell or the perovskite silicon solar cell relates to the electron transport layer commonly provided thereto. A thin film, such as a SnO binding thin film, which forms the electron transport layer, has problems of a low solar cell fill factor (FF) and low energy conversion efficiency due to p-type semiconductor characteristics and high resistance against electron migration.

### [Disclosure]

### [Technical Problem]

The present invention is conceived to solve such problems in the art and it is an aspect of the present invention to provide a perovskite solar cell that includes an improved electron transport layer to improve a fill factor (FF) and energy conversion efficiency of a solar cell, and a tandem solar cell including the same.

### [Technical Solution]

In accordance with one aspect of the present invention, there is provided a perovskite solar cell including: a transparent electrode, a hole transport layer, a perovskite light absorption layer, an electron transport layer, and a metal electrode, wherein the electron transport layer is a graded thin film in which a chemical binding state between elements constituting the electron transport layer gradually changes from a lower portion of the graded thin film to an upper portion thereof.

The transparent electrode may be placed on the substrate, the hole transport layer may be placed on the transparent electrode, the perovskite light absorption layer may be placed on the hole transport layer, the electron transport layer may be placed on the perovskite light absorption layer, and the metal electrode may be placed on the electron transport layer.

The graded thin film may be formed of any one of SnO_{X}, TiOₓ, ZnOₓ, WOₓ, NbOₓ, InOₓ and CeOₓ, and the number of oxygen atoms chemically bound to each of Sn, Ti, Zn W, Nb, In and Ce constituting the graded thin film may gradually change from a lower thin film to an upper thin film.

The graded thin film may be a thin film gradually changing from a lower thin film formed of SnO to an upper thin film formed of SnO₂.

The perovskite solar cell may further include a fullerene-based electron conveying layer interposed between the electron transport layer and the perovskite light absorption layer and composed of PCBM or C60.

In accordance with another aspect of the present invention, there is provided a tandem solar cell including a silicon solar cell and a perovskite solar cell disposed on the silicon solar cell, wherein the perovskite solar cell includes a first transparent electrode, a hole transport layer, a perovskite light absorption layer, an electron transport layer, a second transparent electrode, and a metal electrode; and wherein the electron transport layer is a graded thin film in which a chemical binding state between elements constituting the electron transport layer gradually changes from a lower portion of the graded thin film to an upper portion thereof.

The first transparent electrode may be placed on the silicon solar cell, the hole transport layer may be placed on the first transparent electrode, the perovskite light absorption layer may be placed on the hole transport layer, the electron transport layer may be placed on the perovskite light absorption layer, the second transparent electrode may be placed on the electron transport layer, and the metal electrode may be placed on the second transparent electrode.

The graded thin film may be formed of any one of SnO_{X}, TiOₓ, ZnOₓ, WOₓ, NbOₓ, InOₓ and CeOₓ, and the number of oxygen atoms chemically bound to each of Sn, Ti, Zn W, Nb, In and Ce constituting the graded thin film may gradually change from a lower thin film to an upper thin film.

The graded thin film may be a thin film gradually changing from a lower thin film composed of SnO to an upper thin film composed of SnO₂.

The perovskite solar cell may further include a fullerene-based electron conveying layer 15 interposed between the electron transport layer and the perovskite light absorption layer and composed of PCBM or C60.

### [Advantageous Effects]

In a perovskite solar cell according to embodiments of the present invention and a tandem solar cell including the same, an electron transport layer of the perovskite solar cell is composed of a graded thin film gradually changing from SnO to SnO₂ in an upward direction thereof from a lower portion of the graded thin film to an upper portion thereof, thereby achieving significant improvement in FF (Fill Factor) and energy conversion efficiency.

### [Description of Drawings]

FIG. 1 is a view of one example of a typical perovskite solar cell.
FIG. 2 is a view of a perovskite solar cell according to one embodiment of the present invention.
FIG. 3 is a flowchart illustrating an ALD process for forming a graded thin film composed of SnOₓ according to one embodiment of the present invention.
FIG. 4 is a view of a tandem solar cell including a perovskite solar cell according to one embodiment of the present invention.
FIG. 5 shows XPS analysis results with respect to thin films formed at different flow rates of TDMASn.
FIG. 6 shows FF and energy conversion efficiency values of perovskite solar cells in which electron transport layers were formed at different flow rates of TDMASn, respectively.
FIG. 7 shows XPS analysis results with respect to thin films formed at different flow rates of TDMASn.
FIG. 8 shows FF and energy conversion efficiency values of perovskite solar cells in which electron transport layers were formed at different flow rates of TDMASn, respectively.

### [Best Mode]

Hereinafter, exemplary embodiments of the present invention will be described in detail with reference to the accompanying drawings. However, it should be understood that the present invention is not limited thereto and that various modifications, substitutions, and equivalents can be made by those skilled in the art without departing from the spirit and scope of the present invention.

The terminology used herein is for the purpose of describing particular embodiments and is not intended to be limiting. As used herein, the singular forms "a," "an," and "the" are intended to include the plural forms as well, unless the context clearly indicates otherwise. As used herein, the terms "includes," "comprises," "including," "comprising" and the like specify the presence of stated features, steps, figures, operations, elements, components, and/or groups thereof, but do not preclude the presence or addition of one or more other features, steps, figures, operations, elements, components, and/or groups thereof.

Unless otherwise defined herein, all terms including technical or scientific terms used herein have the same meanings as commonly understood by those skilled in the art to which the present invention belongs. It will be further understood that terms, such as those defined in commonly used dictionaries, should be interpreted as having a meaning that is consistent with their meaning in the context of the specification and relevant art and should not be interpreted in an idealized or overly formal sense unless expressly so defined herein.

In the drawings, like components will be denoted by like reference numerals throughout the specification and repeated descriptions thereof will be omitted. In description of embodiments, portions irrelevant to the description will be omitted for clarity.

When an element or layer is referred to as being "on," "connected to," or "coupled to" another element or layer, it may be directly placed on or may be directly connected or coupled to the other element or layer, or intervening elements or layers may be present therebetween.

Hereinafter, a perovskite solar cell according to the present invention and a tandem solar cell including the same will be described in detail with reference to some exemplary embodiments and the accompanying drawings. However, it should be understood that the present invention is not limited thereto.

### Perovskite solar cell

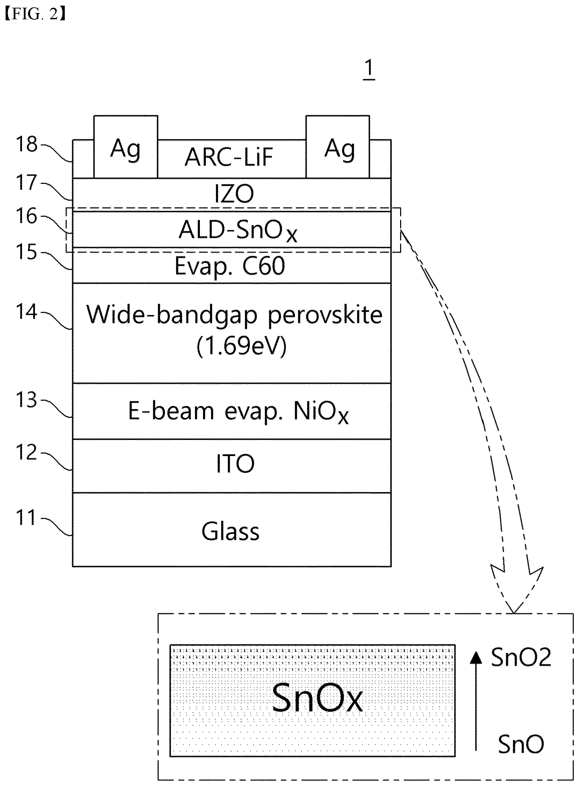

FIG. 2 is a view of a perovskite solar cell 1 according to one embodiment of the present invention.

Referring to FIG. 2, a perovskite solar cell 1 according to the present invention includes a substrate 11, a first transparent electrode 12 disposed on the substrate 11, a hole transport layer 13 disposed on the first transparent electrode 12, a perovskite light absorption layer 14 disposed on the hole transport layer 13, a fullerene-based electron conveying layer 15 disposed on the perovskite light absorption layer 14, an electron transport layer 16 disposed on the electron conveying layer 15, a second transparent electrode 17 disposed on the electron transport layer 16, and a metal electrode 18 disposed on the second transparent electrode 17, wherein the electron transport layer 16 is composed of a graded thin film in which a chemical binding state between elements constituting the electron transport layer gradually changes from a lower portion of the graded thin film to an upper portion thereof.

Referring to FIG. 2, the perovskite solar cell 1 according to the embodiment of the invention has a planar inverse structure (p-i-n planar) among four structures of a general perovskite solar cell, that is, a mesoscopic normal (n-i-p mesoscopic) structure, a planar normal (n-i-p planar) structure, a planar inverse (p-i-n planar) structure, and a mesoscopic inverse (p-i-n mesoscopic) structure.

Here, the structure of the perovskite solar cell 1 shown in FIG. 2 is provided by way of example and the present invention is not limited thereto. The electron transport layer composed of the graded thin film according to the embodiments of the present invention may also be applied to perovskite solar cells having different structures or different stacking sequences therefrom.

The substrate 11 may be formed of borosilicate glass, quartz glass, polyethylene terephthalate (PET), polyethylene naphthalate (PEN), polyimide (PI), polycarbonate (PC), polypropylene (PP), triacetylcellulose (TAC), or polyethersulfone (PES), without being limited thereto.

The first transparent electrode 12 may be formed of a light transmitting conductive material. According to one embodiment, the first transparent electrode 12 may be formed of indium tin oxide (ITO). However, it should be understood that the present invention is not limited thereto and that the light transmitting conductive material may include, for example, a transparent conductive oxide, a carbonaceous conductive material, and a metallic material. The transparent conductive oxide may include, for example, indium tin oxide (ITO), indium cerium oxide (ICO), indium tungsten oxide (IWO), zinc indium tin oxide (ZITO), zinc indium oxide (ZIO), zinc tin oxide (ZTO), gallium indium tin oxide (GITO), gallium indium oxide (GIO), gallium zinc oxide (GZO), aluminum-doped zinc oxide (AZO), fluorine tin oxide (FTO), ZnO, and the like. The carbonaceous conductive material may include, for example, graphene or carbon nanotubes, and the metallic material may include, for example, metal (Ag) nanowires, multilayered metal thin films, such as Au/Ag/Cu/Mg/Mo/Ti. As used herein, the term "transparent" refers to being able to transmit light to a certain degree or more and is not necessarily interpreted to mean completely transparent. It should be understood that the present invention is not limited to the above materials and the first transparent electrode may be formed of a variety of materials and may be modified into a single layer structure or a multilayer structure in various ways.

The hole transport layer 13 may include at least one metal oxide selected from the group consisting of tungsten oxide (WOₓ), molybdenum oxide (MoOₓ), vanadium oxide (V₂O₅), nickel oxide (NiOₓ), and mixtures thereof. In addition, the hole transport layer 13 may include at least one material selected from the group consisting of single-molecule hole transport materials and polymeric hole transport materials. However, it should be understood that the present invention is not limited thereto and any materials typically used in the art may be used for the hole transport layer. For example, the single-molecule hole transport material may be spiro-MeOTAD [2,2',7,7'-tetrakis(N,N-p-dimethoxy-phenylamino)-9,9'-spirobifluorene] and the polymeric hole transport material may be P3HT[poly(3-hexylthiophene)], PTAA(polytriarylamine), poly(3,4-ethylenedioxythiophene), or polystyrene sulfonate(PEDOT:PSS), without being limited thereto.

In addition, the hole transport layer 13 may further include a doping material. The doping material may include at least one dopant selected from the group consisting of Li-based dopants, Co-based dopants, Cu-based dopants, Cs-based dopants and combinations thereof, without being limited thereto.

The hole transport layer 13 may be formed by applying a precursor solution for the hole transport layer onto the first transparent electrode 12, followed by drying the precursor solution.

The perovskite light absorption layer 14 may include a material represented by ABX₃ (where A is a monovalent organoammonium cation or metal cation, B is a divalent metal cation, and X is a halogen anion).

In one or several embodiments, the perovskite light absorption layer 14 may include a perovskite compound having the same formula as above, where A indicates methyl ammonium (CH₃NH³⁺) or ethyl ammonium (CH₃CH₂NH³⁺), B indicates Pb or Sn, and X indicates I, Br or Cl, without being limited thereto. Alternatively, these may be used as a mixture thereof.

The perovskite compound may include, for example, CH₃NH₃PbI₃, CH₃NH₃PbIₓCl₃₋ₓ, MAPbI₃, CH₃NH₃PbIₓBr₃₋ₓ, CH₃NH₃PbClₓBr₃₋ₓ, HC(NH₂)₂PbI₃, HC(NH₂)₂PbIₓCl₃₋ₓ, HC(NH₂)₂PbIₓBr₃₋ₓ, HC(NH₂)₂PbClₓBr₃₋ₓ, (CH₃NH₃)(HC(NH₂)₂)_{1-y}Pbl₃, (CH₃NH₃)(HC(NH₂)₂)_{1-y}PbIₓCl₃₋ₓ, (CH₃NH₃)(HC(NH₂)₂)_{1-y}PbIₓBr₃₋ₓ, (CH₃NH₃)(HC(NH₂)₂)_{1-y}PbClₓBr₃₋ₓ, and the like (0≤x, y≤1). In addition, the perovskite compound may include a compound represented by ABX₃, where A is partially doped with Cs.

Perovskite exhibits strong solar absorption, a low non-radiative carrier recombination rate, and high carrier mobility, and does not allow a defect causing non-luminous carrier recombination to be formed in the bandgap or at a deep level, thereby increasing conversion efficiency.

The electron conveying layer 15 is placed on the perovskite light absorption layer 14 and may be formed of a fullerene-based compound composed of PCBM or C60. However, this structure is not essential and, optionally, an upper electron transport layer 16 may be formed directly on the perovskite light absorption layer 14 without the electron conveying layer 15, as shown in FIG. 2.

In the structure where the electron transport layer 16 formed of TiOₓ, ZnOₓ or the like is formed on the perovskite light absorption layer 14, there is a problem of decomposition of perovskite upon direct contact between the electron transport layer 16 and the perovskite light absorption layer 14.

In particular, when the electron transport layer is formed of ZnO, deprotonation of methyl ammonium cations by ZnO occurs at the interface of ZnO/perovskite, thereby converting methyl ammonium into methylamine. Methylamine has a very low boiling point to be easily gasified at room temperature. As a result, methyl ammonium is lost, causing decomposition of the perovskite.

According to this embodiment, the fullerene-based electron conveying layer 15 composed of PCBM or C60 is formed between the electron transport layer 16 and the perovskite light absorption layer 14, thereby preventing decomposition of the perovskite caused by direct contact between the electron transport layer formed of TiOₓ, ZnOₓ or the like and the perovskite light absorption layer.

The electron transport layer 16 is placed on top of the electron conveying layer 15 and transports electrons, which are generated from the perovskite light absorption layer, to the second transparent electrode.

According to one embodiment, the electron transport layer 16 may be a thin film composed of SnOₓ and may be composed of a graded thin film that gradually changes from a lower thin film composed of SnO to an upper thin film composed of SnO₂, as shown in FIG. 2.

The graded thin film composed of SnOₓ according to the embodiment may be formed by atomic layer deposition (ALD) at a low temperature of 150°C or less.

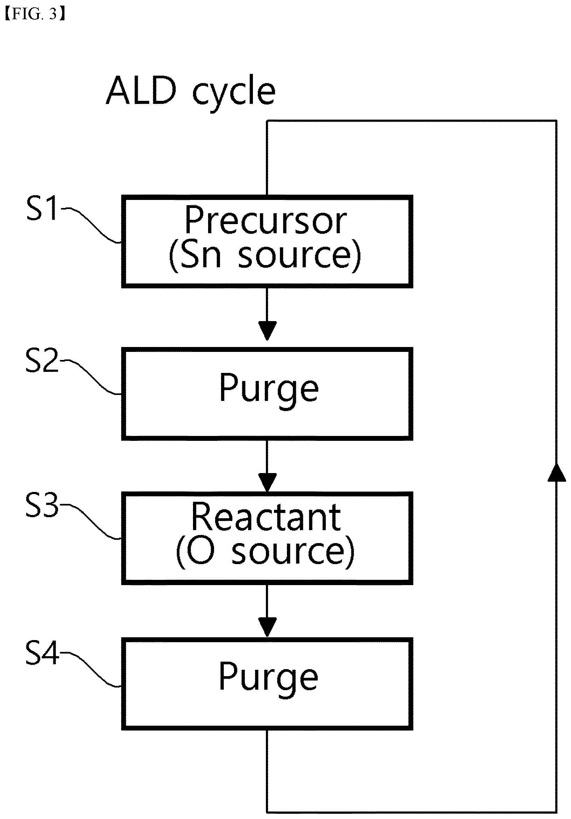

FIG. 3 is a flowchart illustrating an ALD process for forming a graded thin film composed of SnOₓ according to one embodiment of the present invention.

As shown in FIG. 3, a precursor gas for a source of tin (Sn) constituting the graded thin film is injected and adsorbed onto a surface of a matrix (S1). The source of tin (Sn) may include any one of TDMASn, TEMASn, Sn(dmamp)₂ and SnCl₄. In one embodiment, TDMASn is used as the source of tin.

Next, purging is performed to remove residues (S2).

Next, a source of oxygen (O) is supplied as a reactant constituting the graded thin film (S3). The source of oxygen (O) may include any one of H₂O, H₂O₂, O₃ and O₂. In one embodiment, H₂O is used as the source of oxygen (O).

Next, purging is performed to remove residues (S4).

In the ALD process according to the embodiment, a cycle composed of S1 to S4 is repeated.

Upon repetition of the cycle, the lowermost portion of the electron transport layer 16 is substantially formed of SnO alone and the uppermost portion of the electron transport layer 16 is substantially formed of SnO₂ alone through gradual increase in ratio of SnO₂ to SnO.

Here, the flow rate of TDMASn acting as the source of tin (Sn) is important in formation of the graded thin film that gradually changes from the lower thin film composed of SnO to the upper thin film composed of SnO₂.

If the flow rate of TDMASn as the source of tin (Sn) is not secured, the graded thin film is not formed and a thin film composed only of SnO is formed, thereby causing deterioration in fill factor (FF) and energy conversion efficiency due to high resistance against electron migration. According to the present invention, the flow rate of TDMASn is limited to 30 sccm or more.

According to the embodiment of the invention, when the flow rate of TDMASn acting as the source of tin (Sn) is set in the range of 30 sccm to 90 sccm, a graded SnOₓ thin film gradually changing from the lower thin film composed of SnO to the upper thin film composed of SnO₂ may be formed. Here, the flow rate of H₂O acting as the source of oxygen (O) may be set in the range of 10 sccm to 100 sccm and the process temperature may be set to 80°C.

The presence of the graded SnOₓ thin film in the electron transport layer may be confirmed using X-ray Photoelectron Spectroscopy (XPS) surface analysis equipment.

The XPS surface analysis equipment is an instrument that measures a composition and binding characteristics of a sample based on kinetic energy and intensity of photoelectrons emitted from a surface of the sample by shooting X-rays towards the sample.

Here, it should be understood that the upper electron transport layer 16 composed of the SnOₓ graded thin film is provided by way of example and the graded thin film according to the present invention may be formed of any one of TiOₓ, ZnOₓ, WOₓ, NbOₓ, InOₓ and CeOₓ.

That is, like the SnOₓ graded thin film, the graded thin film formed of any one of TiOₓ, ZnOₓ, WOₓ, NbOₓ, InOₓ and CeOₓ gradually changes from a lower thin film having a smaller number of oxygen atoms chemically bound to each of Ti, Zn W, Nb, In and Ce to an upper thin film having a greater number of oxygen atoms chemically coupled thereto.

The graded thin film formed of any one of TiOₓ, ZnOₓ, WOₓ, NbOₓ, InOₓ and CeOₓ may be formed by atomic layer deposition (ALD) shown in FIG. 3.

Here, although the flow rates of sources of a reactant constituting each of TiOₓ, ZnOₓ, WOₓ, NbOₓ, InOₓ and CeOₓ and the process temperature may be different from the flow rates and the process temperature for the SnOₓ graded thin film, the graded thin film formed of each of TiOx, ZnOx, WOx, NbOx, and InOx requires a predetermined flow rate or more of the reactant coupled to oxygen O in the ALD process, like the SnOₓ graded thin film gradually changing from the lower thin film to the upper thin film.

According to the embodiment, the second transparent electrode 17 may be formed of indium zinc oxide (IZO). However, it should be understood that the present invention is not limited thereto and the second transparent electrode 17 may be formed of the same material as the first transparent electrode, such as zinc oxide (AZO; aluminum-zinc oxide; ZnO:Al), indium tin oxide (ITO), fluorine-doped tin oxide (FTO), and the like.

According to the embodiment, the electron transport layer 16 and the electron conveying layer 15 are present between the second transparent electrode 17 and the perovskite light absorption layer 14 to act as buffer layers, the perovskite light absorption layer 14 can be protected even upon formation of the second transparent electrode 17 composed of IZO through deposition of IZO on the perovskite light absorption layer 14 by sputtering.

The metal electrode 18 is electrically connected to the outside and may be formed by deposition of a patterned silver (Ag) thin film.

### Tandem solar cell including perovskite solar cell

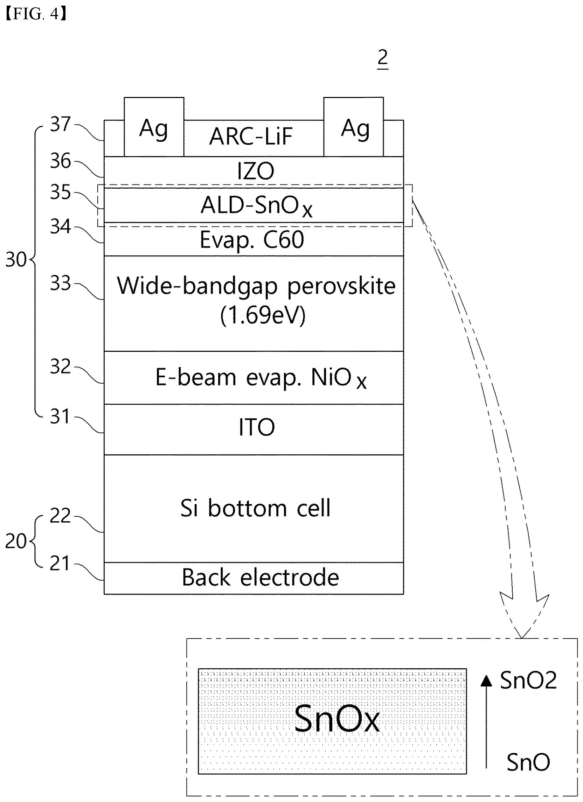

FIG. 4 is a view of one embodiment of a tandem solar cell 2 including a perovskite solar cell according to one embodiment of the present invention.

As shown in FIG. 4, a tandem solar cell including a perovskite solar cell according to one embodiment of the present invention may include a silicon solar cell (lower cell) 20, a perovskite solar cell (upper cell) 30 formed on the silicon solar cell, and a bonding layer (not shown) bonding the silicon solar cell 20 to the perovskite solar cell 30 to electrically connect the silicon solar cell 20 to the perovskite solar cell 30. Such a bonding layer may be realized using a transparent conductive oxide (TCO), a carbonaceous conductive material, a metallic material, or a conductive polymer so as to allow long wavelength light passing through the perovskite solar cell 30 to enter the silicon solar cell 20 at a lower side without transmittance loss.

In one or several embodiments, the tandem solar cell 2 may be formed by spin-coating a solution for the bonding layer onto the top of the silicon solar cell 20 and bonding the perovskite solar cell 30 to the surface of the transparent bonding layer solution coated on the silicon solar cell, followed by curing through UV treatment or heat treatment. However, it should be understood that this method is illustrated by way of example and the tandem solar cell may be formed by other methods known in the art.

The silicon solar cell 20 may be a silicon solar cell having a bandgap of 1.0 eV to 1.2 eV. The silicon solar cell 20 may include a back electrode 21, which is disposed on the substrate and is formed of a metal or a metal alloy, and a silicon semiconductor layer 22 disposed on the back electrode.

The back electrode 21 may be formed on the substrate (not shown) for electrical connection to the outside. In one or several embodiments, the back electrode may be formed through e-beam evaporation vacuum deposition and may be formed of Ag, Ti, Au, and the like.

The silicon semiconductor layer 22 may include a p-type silicon semiconductor layer and an n-type silicon semiconductor layer disposed on the p-type silicon semiconductor layer.

The perovskite solar cell 30 may include a first transparent electrode 31, a hole transport layer 32, a perovskite light absorption layer 33, an electron conveying layer 34, an electron transport layer 35, a second transparent electrode 36, and a metal electrode 37.

In the embodiment shown in FIG. 4, the first transparent electrode 31 may be formed on the silicon solar cell 20, the hole transport layer 32 may be formed on the first transparent electrode, the perovskite light absorption layer 33 may be formed on the hole transport layer 32, the electron conveying layer 34 may be formed on the perovskite light absorption layer 33, the electron transport layer 35 may be formed on the electron conveying layer 34 formed of a fullerene-based compound, the second transparent electrode 36 may be formed on the electron transport layer 35, and the metal electrode 37 may be formed on the second transparent electrode 36.

The first transparent electrode 31 may be formed of a light transmitting conductive material. According to the embodiment, the first transparent electrode 31 may be formed of indium tin oxide (ITO). However, it should be understood that the present invention is not limited thereto and the light transmitting conductive material may include, for example, a transparent conductive oxide, a carbonaceous conductive material, a metallic material, and the like. The transparent conductive oxide may include, for example, indium tin oxide (ITO), indium cerium oxide (ICO), indium tungsten oxide (IWO), zinc indium tin oxide (ZITO), zinc indium oxide (ZIO), zinc tin oxide (ZTO), gallium indium tin oxide (GITO), gallium indium oxide (GIO), gallium zinc oxide (GZO), aluminum-doped zinc oxide (AZO), fluorine tin oxide (FTO), ZnO, and the like. The carbonaceous conductive material may include, for example, graphene or carbon nanotubes, and the metallic material may include, for example, metal (Ag) nanowires and multilayered metal thin films, such as Au/Ag/Cu/Mg/Mo/Ti. As used herein, the term "transparent" refers to being able to transmit light to a certain degree or more and is not necessarily interpreted to mean completely transparent. It should be understood that the present invention is not limited to the above materials and the first transparent electrode may be formed of a variety of materials and may be modified into a single layer structure or a multilayer structure in various ways.

The hole transport layer 32 may include at least one metal oxide selected from the group consisting of tungsten oxide (WOₓ), molybdenum oxide (MoOₓ), vanadium oxide (V₂O₅), nickel oxide (NiOₓ), and mixtures thereof. In addition, the hole transport layer 32 may include at least one material selected from the group consisting of single-molecule hole transport materials and polymeric hole transport materials. However, it should be understood that the present invention is not limited thereto and any materials typically used in the art may be used for the hole transport layer. For example, the single-molecule hole transport material may be spiro-MeOTAD [2,2',7,7'-tetrakis(N,N-p-dimethoxy-phenylamino)-9,9'-spirobifluorene] and the polymeric hole transport material may be P3HT[poly(3-hexylthiophene)], PTAA(polytriarylamine), poly(3,4-ethylenedioxythiophene), or polystyrene sulfonate(PEDOT:PSS), without being limited thereto.

In addition, the hole transport layer 32 may further include a doping material. The doping material may include at least one dopant selected from the group consisting of Li-based dopants, Co-based dopants, Cu-based dopants, Cs-based dopants and combinations thereof, without being limited thereto.

The hole transport layer 32 may be formed by applying a precursor solution for the hole transport layer onto the first transparent electrode 31, followed by drying the precursor solution.

The perovskite light absorption layer 33 may include a material represented by ABX₃ (where A is a monovalent organoammonium cation or metal cation, B is a divalent metal cation, and X is a halogen anion).

In one or several embodiments, the perovskite light absorption layer 33 may include a perovskite compound having the same formula as above, where A indicates methyl ammonium (CH₃NH³⁺) or ethyl ammonium (CH₃CH₂NH³⁺), B indicates Pb or Sn, and X indicates I, Br or Cl, without being limited thereto. Alternatively, these may be used as a mixture thereof.

The perovskite compound may include, for example, CH₃NH₃PbI₃, CH₃NH₃PbIₓCl₃₋ₓ, MAPbI₃, CH₃NH₃PbIₓBr₃₋ₓ, CH₃NH₃PbClₓBr₃₋ₓ, HC(NH₂)₂PbI₃, HC(NH₂)₂PbIₓCl₃₋ₓ, HC(NH₂)₂PbIₓBr₃₋ₓ, HC(NH₂)₂PbClₓBr₃₋ₓ, (CH₃NH₃)(HC(NH₂)₂)_{1-y}Pbl₃, (CH₃NH₃)(HC(NH₂)₂)_{1-y}PbIₓCl₃₋ₓ, (CH₃NH₃)(HC(NH₂)₂)_{1-y}PbIₓBr₃₋ₓ, (CH₃NH₃)(HC(NH₂)₂)_{1-y}PbClₓBr₃₋ₓ, and the like (0≤x, y≤1). In addition, The perovskite compound may include a compound represented by ABX₃, where A is partially doped with Cs.

The electron conveying layer 34 is placed on the perovskite light absorption layer 33 and may be formed of a fullerene-based compound composed of PCBM or C60. However, this structure is not essential and, optionally, an upper electron transport layer may be formed directly on the perovskite light absorption layer 33 without the electron conveying layer 34.

For the electron transport layer 35 formed of TiOₓ, ZnOₓ or the like, the electron conveying layer 34 is placed between the electron transport layer 35 and the perovskite light absorption layer 33 to prevent direct contact between the electron transport layer and the perovskite light absorption layer, thereby preventing decomposition of the perovskite caused by TiOₓ, ZnOₓ or the like.

The electron transport layer 35 is placed on top of the electron conveying layer 34 and transports electrons, which are generated from the perovskite light absorption layer 33, to the second transparent electrode 36.

According to one embodiment, the electron transport layer 35 may be a thin film composed of SnOₓ and may be composed of a graded thin film that gradually changes from a lower thin film composed of SnO to an upper thin film composed of SnO₂, as shown in FIG. 2.

The graded thin film composed of SnOₓ according to the embodiment may be formed by atomic layer deposition (ALD) shown in FIG. 3.

To form the graded thin film gradually changing from the lower thin film composed of SnO to the upper thin film composed of SnO₂, the flow rate of TDMASn acting as the source of tin (Sn) may be set in the range of 30 sccm to 90 sccm, the flow rate of H₂O acting as the source of oxygen (O) may be set in the range of 10 sccm to 100 sccm, and the process temperature may be set to 80°C.

Here, it should be understood that the upper electron transport layer composed of the SnOₓ graded thin film is provided by way of example and the graded thin film according to the present invention may be formed of any one of TiOₓ, ZnOₓ, WOₓ, NbOₓ, InOₓ and CeOₓ.

That is, like the SnOₓ graded thin film, the graded thin film formed of any one of TiOₓ, ZnOₓ, WOₓ, NbOₓ, InOₓ and CeOₓ gradually changes from a lower thin film having a smaller number of oxygen atoms chemically bound to each of Ti, Zn W, Nb, In and Ce to an upper thin film having a greater number of oxygen atoms chemically bound thereto.

The graded thin film formed of any one of TiOₓ, ZnOₓ, WOₓ, NbOₓ, InOₓ and CeOₓ may be formed by atomic layer deposition (ALD) shown in FIG. 3.

Here, although the flow rates of sources of a reactant constituting each of TiOₓ, ZnOₓ, WOₓ, NbOₓ, InOₓ and CeOₓ and the process temperature may be different from the flow rates and the process temperature for the SnOₓ graded thin film, the graded thin film formed of each of TiOx, ZnOx, WOx, NbOx, and InOx requires a predetermined flow rate or more of the reactant coupled to oxygen O in the ALD process, like the SnOₓ graded thin film gradually changing from the lower thin film to the upper thin film.

According to the embodiment, the second transparent electrode 36 may be formed of indium zinc oxide (IZO). However, it should be understood that the present invention is not limited thereto and the second transparent electrode 36 may be formed of the same material as the first transparent electrode 31, such as zinc oxide (AZO; aluminum-zinc oxide; ZnO:Al), indium tin oxide (ITO), fluorine-doped tin oxide (FTO), and the like.

In the structure of the tandem solar cell according to this embodiment, the second transparent electrode 36 is an essential component. When sunlight is irradiated from the top to the bottom of the tandem solar cell 2 shown in FIG. 4, the metal electrode 37 is formed in a lattice pattern in order to transmit the sunlight and voids are inevitably generated between lattices. For this reason, the second transparent electrode 36 is required to allow electrons generated in the perovskite light absorption layer 33 and reaching the voids to move to the metal electrode 37 through lateral migration.

The metal electrode 37 is electrically connected to the outside and may be formed by depositing a silver (Ag) thin film in a grid pattern so as to allow sunlight to pass therethrough.

### Effects of electron transport layer of the present invention composed of graded thin film

Next, the effects of the graded thin film according to embodiments of the present invention used in the perovskite solar cell and the tandem solar cell including the same will be described.

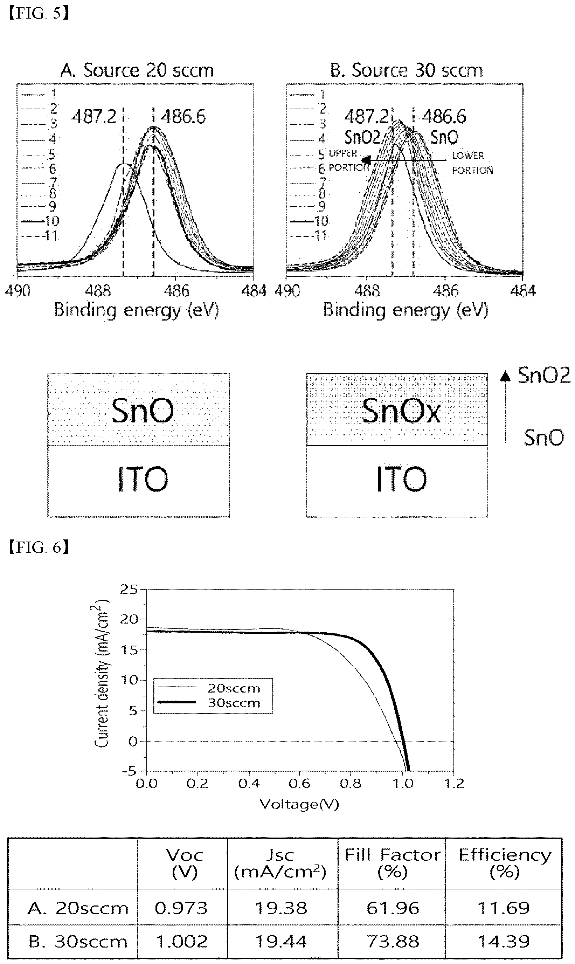

FIG. 5 shows XPS analysis results with respect to thin films formed at different flow rates of TDMASn set to 20 sccm and 30 sccm, respectively, and FIG. 6 shows FF and energy conversion efficiency values of perovskite solar cells in which electron transport layers were formed at different flow rates of TDMASn acting as the source of tin (Sn) set to 20 sccm and 30 sccm, respectively.

A thin film shown in A of FIG. 5 was formed on an ITO transparent electrode by atomic layer deposition (ALD) shown in FIG. 3 under conditions that the flow rate of TDMASn acting as the source of tin (Sn) was set to 20 sccm, the flow rate of H₂O acting as the source of oxygen (O) was set to 30 sccm, and the process temperature was set to 80°C, and a thin film shown in B of FIG. 5 was formed by ALD under the same conditions as those shown in A of FIG. 5 except that the flow rate of TDMASn acting as the source of tin (Sn) was set to 30 sccm.

XPS (X-ray Photoelectron Spectroscopy) analysis equipment is surface analysis equipment that measures a composition and binding characteristics of a material based on kinetic energy and intensity of photoelectrons emitted by the photoelectric effect of X-rays incident on a sample upon shooting X-rays to the sample.

From the XPS analysis graphs shown in FIG. 5, it could be seen that the thin film shown in A of FIG. 5 was formed in a monolayer structure of SnO having a single binding energy peak of 486.6 eV and the graded thin film according to the present invention was not formed.

Further, it could be seen from the XPS analysis graphs that the thin film shown in B of FIG. 5 had a binding energy peak gradually changing from 486.6 eV (SnO) at a lower portion thereof to 487.2 eV (SnO₂) at an upper portion thereof.

In the thin film shown in B of FIG. 5, the lowermost portion was substantially formed of SnO alone and the uppermost portion was substantially formed of SnO₂ alone through increase in the ratio of SnO₂ to SnO. That is, it could be seen that the thin film shown in B of FIG. 5 was formed as the graded thin film according to the present invention.

In FIG. 6, A shows conditions for fabrication of a perovskite solar cell, in which a monolayer SnO thin film (not a graded thin film) was formed as the electron transport layer, as shown in A of FIG. 5, by atomic layer deposition at the flow rate of TDMASn as the source of tin (Sn) set to 20 sccm, and shows that the perovskite solar cell manufactured using the SnO thin film had a fill factor (FF) of 61.96% and an energy conversion efficiency of 11.69%.

In FIG. 6, B shows conditions for fabrication of a perovskite solar cell, in which a graded thin film was formed as the electron transport layer, as shown in B of FIG. 5, by atomic layer deposition at the flow rate of TDMASn as the source of tin (Sn) set to 30 sccm, and shows that the perovskite solar cell manufactured using the graded thin film had a fill factor (FF) of 73.88% and an energy conversion efficiency of 14.39%.

That is, it can be seen that the perovskite solar cell including the electron transport layer corresponding to the graded thin film gradually changing from SnO to SnO₂ in an upward direction from a lower portion thereof to an upper portion thereof has much better properties in terms of FF (fill factor) and energy conversion efficiency than the perovskite solar cell including the electron transport layer corresponding to the monolayer SnO thin film.

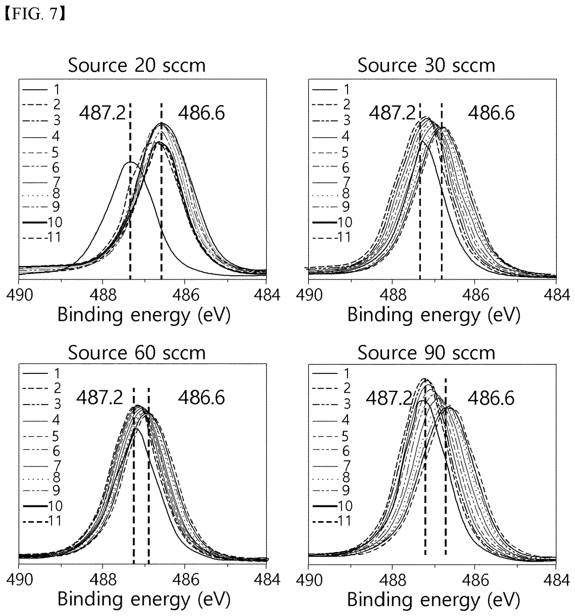

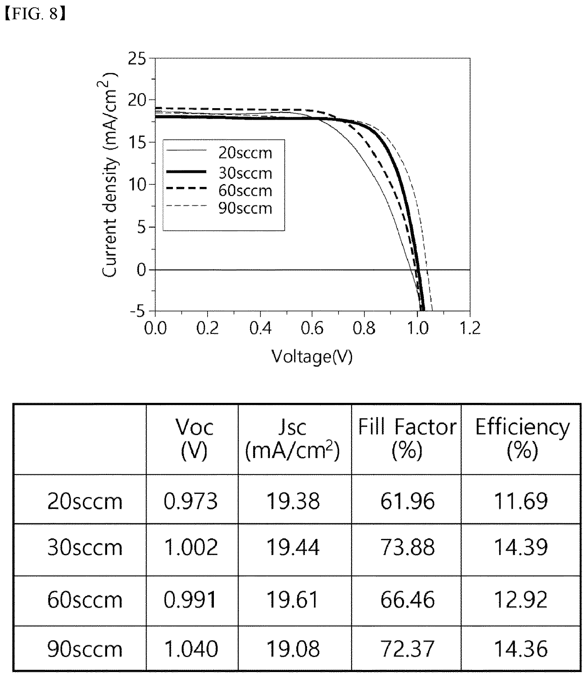

FIG. 7 shows XPS analysis results with respect to thin films formed at different flow rates of TDMASn acting as the source of tin (Sn) set to 20 sccm, 30 sccm, 60 sccm and 90 sccm, respectively, and FIG. 8 shows FF and energy conversion efficiency values of perovskite solar cells in which electron transport layers were formed at different flow rates of TDMASn acting as the source of tin (Sn) set to 20 sccm, 30 sccm, 60 sccm and 90 sccm, respectively.

Referring to FIG. 7, each of the thin films was formed on an ITO transparent electrode by atomic layer deposition (ALD) shown in FIG. 3 under the same conditions (that is, at the flow rate of H₂O acting as the source of oxygen set to 30 sccm and at a process temperature of 80°C) except that the flow rate of TDMASn acting as the source of tin (Sn) was set to 20 sccm, 30 sccm, 60 sccm and 90 sccm.

As shown in the XPS analysis graphs of FIG. 7, it could be seen that, except for the thin film formed at the flow rate of TDMASn acting as the source of tin (Sn) set to 20 sccm, all of the thin films formed at the flow rates of 30 sccm, 60 sccm and 90 sccm had binding energy peaks gradually changing from a binding energy peak representing SnO to a binding energy peak representing SnO₂ in the upward direction from a lower portion of the thin film to an upper portion thereof.

Thus, it can be seen that, when the flow rate of TDMASn as the source of tin (Sn) is set to 30 sccm or more (that is, 30 sccm, 60 sccm and 90 sccm), a graded thin film gradually changing from SnO to SnO₂ in the upward direction is formed.

FIG. 8 shows conditions for fabrication of perovskite solar cells in which graded thin films were formed as the electron transport layer by atomic layer deposition under the same conditions as in FIG. 7 (that is, at the flow rate of H₂O acting as a source of oxygen set to 30 sccm and at a process temperature of 80°C) except that the flow rate of TDMASn acting as the source of tin (Sn) was set to 20 sccm, 30 sccm, 60 sccm and 90 sccm.

Referring to FIG. 8, it could be seen that, when the graded thin films according to the embodiments of the present invention were formed as the electron transport layer (that is, when the flow rate of TDMASn was set to 20 sccm, 30 sccm, 60 sccm and 90 sccm), the perovskite solar cells had a much higher fill factor (FF) in the range of 66.46% to 73.88% and a much better energy conversion efficiency in the range of 12.92% to 14.39% than the other perovskite solar cell (the flow rate of TDMASn was set to 20sccm).

It should be understood that the above description of the invention is provided for illustration only and that various modifications, changes, alterations, and equivalent embodiments can be made by those skilled in the art without departing from the spirit and scope of the invention. Therefore, it should be understood that the above embodiments are provided for illustration only and are not to be construed in any way as limiting the invention. For example, each component described as unitary may also be implemented as distributed, and similarly, components described as distributed may also be implemented as combined.

The scope of the invention is defined by the following claims and should be interpreted as including the meaning and scope of the claims and all modifications or variations derived from equivalents thereto.

### [Industrial Applicability]

The present invention is applicable to the field of manufacturing perovskite solar cells.

## Claims

1. A perovskite solar cell comprising: a transparent electrode, a hole transport layer, a perovskite light absorption layer, an electron transport layer, and a metal electrode, wherein the electron transport layer is a graded thin film in which a chemical binding state between elements constituting the electron transport layer gradually changes from a lower portion of the graded thin film to an upper portion thereof.

2. The perovskite solar cell according to claim 1, wherein the hole transport layer is placed on the transparent electrode, the perovskite light absorption layer is placed on the hole transport layer, the electron transport layer is placed on the perovskite light absorption layer, and the metal electrode is placed on the electron transport layer.

3. The perovskite solar cell according to claim 1 or 2, wherein the graded thin film is formed of any one of SnO_{X}, TiOₓ, ZnOₓ, WOₓ, NbOₓ, InOₓ and CeOₓ, and the number of oxygen atoms chemically bound to each of Sn, Ti, Zn W, Nb, In and Ce constituting the graded thin film gradually changes from a lower thin film to an upper thin film.

4. The perovskite solar cell according to claim 1 or 2, wherein the graded thin film is a thin film gradually changing from a lower thin film composed of SnO to an upper thin film composed of SnO₂.

5. The perovskite solar cell according to claim 1 or 2, further comprising:
a fullerene-based electron conveying layer interposed between the electron transport layer and the perovskite light absorption layer and composed of PCBM or C60.

6. A tandem solar cell comprising a silicon solar cell and a perovskite solar cell disposed on the silicon solar cell,
wherein the perovskite solar cell comprises a first transparent electrode, a hole transport layer, a perovskite light absorption layer, an electron transport layer, a second transparent electrode, and a metal electrode; and
wherein the electron transport layer is a graded thin film in which a chemical binding state between elements constituting the electron transport layer gradually changes from a lower portion of the graded thin film to an upper portion thereof.

7. The tandem solar cell according to claim 6, wherein the first transparent electrode is placed on the silicon solar cell, the hole transport layer is placed on first transparent electrode, the perovskite light absorption layer is placed on the hole transport layer, the electron transport layer is placed on the perovskite light absorption layer, the second transparent electrode is placed on the electron transport layer, and the metal electrode is placed on the second transparent electrode.

8. The tandem solar cell according to claim 6 or 7, wherein the graded thin film is formed of any one of SnO_{X}, TiOₓ, ZnOₓ, WOₓ, NbOₓ, InOₓ and CeOₓ, and the number of oxygen atoms chemically bound to each of Sn, Ti, Zn W, Nb, In and Ce constituting the graded thin film gradually changes from a lower thin film to an upper thin film.

9. The tandem solar cell according to claim 6 or 7, wherein the graded thin film is a thin film gradually changing from a lower thin film formed of SnO to an upper thin film formed of SnO₂.

10. The tandem solar cell according to claim 6 or 7, further comprising:
a fullerene-based electron conveying layer interposed between the electron transport layer and the perovskite light absorption layer and composed of PCBM or C60.
